# EUROPÄISCHE PATENTSCHRIFT

(11) **EP 1 672 692 B1**
(45) Veröffentlichungstag und Bekanntmachung des Hinweises auf die Patenterteilung: **07.01.2015**
(21) Anmeldenummer: 05405678.3
(22) Anmeldetag: 30.11.2005
(51) Int. Cl.: H01L 25/07, H01L 23/36, H01L 23/051, H01L 23/40, H01L 23/367, H01L 23/467

(54) **Leistungshalbleiter-Modul**
Power semiconductor module
Module semiconducteur de puissance

(30) Priorität: 16.12.2004 EP 04405776
(43) Veröffentlichungstag der Anmeldung: 21.06.2006
(73) Patentinhaber: ABB Research Ltd, 8050 Zürich (CH)
(72) Erfinder: Knapp, Wolfgang, 5600 Lenzburg (CH); Apeldoorn, Stefanie, 5426 Lengnau (CH)
(74) Vertreter: ABB Patent Attorneys

(56) Entgegenhaltungen:
- EP-A- 1 253 637
- EP-A- 1 284 503
- DE-A1- 19 707 514
- DE-U1- 8 909 971
- GB-A- 1 294 532
- US-A- 4 392 153
- US-A- 5 132 777
- US-A1- 2003 122 261
- US-A1- 2004 070 060
- PATENT ABSTRACTS OF JAPAN Bd. 2003, Nr. 12, 5. Dezember 2003 (2003-12-05) -& JP 2003 243862 A (MEIDENSHA CORP), 29. August 2003 (2003-08-29)

## Beschreibung

### Technisches Gebiet

Die Erfindung bezieht sich auf das Gebiet der Leistungshalbleitertechnik. Sie geht aus von einem Leistungshalbleiter-Modul gemäss dem Oberbegriff des Anspruchs 1.

### Stand der Technik

In der Druckschrift EP 0 921 565 A2 wird ein Kunststoff-gekapseltes Halbleiter-Modul mit einem Gehäuse beschrieben, in dem Halbleiterchips mit einer ersten Hauptelektrodenseite untereinander mit Bonddrähten elektrisch verbunden sind. Auf der zweiten, der ersten Hauptelektrodenseite abgewandten Seite ist eine Kupferschicht, darauf eine Platte aus isolierendem Substrat und auf dieser wiederum ein Kühlblech angeordnet. Mit der Platte aus isolierendem Substrat werden die Halbleiterchips elektrisch gegenüber dem Kühlblech isoliert. Das Kühlblech steht mit der Platte aus isolierendem Material in thermischer Verbindung. Typischerweise ist die dem Isolator abgewandte Seite des Kühlblechsmit einem Kühlkörper, über den Wärme abgeführt wird, in thermischer Verbindung. Senkrecht zu der ersten Hauptseite sind externe Leistungsanschlüsse auf den Halbleiterchips oder der Kupferschicht angebracht. Das Gehäuse besteht aus einem isolierenden thermoplastischen Material. Üblich sind auch Gehäuse aus anderem Polymer Material. Das Gehäuse umschliesst die Halbleiteranordnung bis auf die Enden der Leistungsanschlüsse und bis auf die dem Isolator abgewandte Seite des Kühlblechs. Ein solches Gehäuse wird typischerweise in einer Gussform hergestellt. Bei grösseren Halbleitermodulen oder grösseren Gehäusen werden Anordnungen mit Kunststoff-gekapselten Halbleitergehäusen sehr teuer, weil die Gussformen teuer sind und viel teures thermoplastisches oder Polymer Material erforderlich ist. Durch die einseitige Kühlung derartiger Halbleitermodule kann Wärme nicht optimal abgeführt werden, was den Leistungsbereich der Halbleitermodule begrenzt.

US 2004/0070060 beschreibt ein Leistungshalbleiter Modul mit zwei Halbleiterchips und an beiden Hauptseiten der Chips angeordneten Kühlplatten, welche hervorstehende Teile aufweisen und über diese sowohl thermisch wie auch elektrisch mit den Hauptseiten der Halbleiterchips verbunden sind. Die Kühlplatten sind jeweils auf der den Halbleiterchips gegenüberliegenden Seite mit einer elektrisch leitenden Platte verbunden, über welche die Chips von aussen kontaktiert werden. An diese elektrisch leitenden Platten schliessen je eine thermisch leitende und elektrisch isolierende Schicht an, welche wiederum in Kontakt mit einem Kühlkörper stehen. Die Kühlkörper werden von aussen miteinander verschraubt, so dass alle dazwischen liegenden Elemente zusammen fest zusammengepresst werden. Somit wird der Druck von den Kühlkörpern aus auf alle dazwischen liegenden Elemente übertragen. Da die Kühlkörper mit aussen befindlichen Schrauben zusammengeschraubt werden, besteht die Gefahr, dass sie sich zur Mitte hin durchbiegen, d.h. gerade in dem Bereich, in dem ein guter Kontakt zur Wärmeübertragung erforderlich ist.

### Darstellung der Erfindung

Aufgabe der Erfindung ist daher, ein Leistungshalbleiter-Modul anzugeben, welches eine verbesserte Kühlung gegenüber dem Stand der Technik aufweist.

Diese Aufgabe wird erfindungsgemäss durch die Merkmale des unabhängigen Patentanspruchs 1 gelöst.

Das erfindungsgemässe Leistungshalbleiter-Modul weist mindestens einen Halbleiterchip mit einer ersten Hauptelektrodenseite und einer der ersten Hauptelektrodenseite gegenüberliegenden zweiten Hauptelektrodenseite auf. Die erste Hauptelektrodenseite ist thermisch und elektrisch mit einer ersten Grundplatte kontaktiert. Diese erste Grundplatte ist auf der der ersten Hauptelektrodenseite abgewandten Seite der ersten Grundplatte thermisch mit einer ersten Kühlvorrichtung kontaktiert. Die erste Kühlvorrichtung weist ein erstes Hauptelektrodenanschlusselement und einen Kühlkörper auf, wobei das erste Hauptelektrodenanschlusselement mit der der ersten Hauptelektrodenseite abgewandten Seite der ersten Grundplatte thermisch und elektrisch kontaktiert ist und wobei der Kühlkörper mit der der ersten Hauptelektrodenseite abgewandten Seite des ersten Hauptelektrodenanschlusselements thermisch kontaktiert ist. Die zweite Hauptelektrodenseite ist erfindungsgemäss thermisch und elektrisch mit einer zweiten Grundplatte kontaktiert. Diese zweite Grundplatte ist auf der der zweiten Hauptelektrodenseite abgewandten Seite der zweiten Grundplatte thermisch mit einer zweiten Kühlvorrichtung kontaktiert. Das erfindungsgemässe Leistungshalbleiter-Modul weist ein Gehäuse auf, in welchem der mindestens eine Halbleiterchip und die erste und zweite Kühlvorrichtung angeordnet sind, wobei der Kühlkörper der ersten Kühlvorrichtung sich gegen das Gehäuse abstützt. Das erfindungsgemässe Leistungshalbleiter-Modul weist eine sehr gute Kühlung auf, da Wärme auf beiden Hauptelektrodenseiten der Halbleiterchips abführbar ist. Da der Druck von aussen auf die Anordnung mit den beiden Kühlvorrichtungen, Grundplatten und Halbleiterchips übertragen wird, kann ein guter thermischer und gegebenenfalls auch elektrischer Kontakt an allen Kontaktflächen errecht werden und somit ein guter Wärmeabtransport erzielt werden. Durch das Abstützen des mindestens einen Kühlkörpers gegen das Gehäuse wird das Halbleiter-Modul mechanisch stabil, beispielsweise gegen Stösse und Vibrationen.
Das erfindungsgemässe Halbleitermodul kann kompakt gebaut werden und es ist für den Hochleistungsbereich geeignet.

Diese und weitere Aufgaben, Vorteile und Merkmale der vorliegenden Erfindung werden aus der nachfolgenden detaillierten Beschreibung von bevorzugten Ausführungsbeispielen der Erfindung in Verbindung mit den Zeichnungen offensichtlich.

### Kurze Beschreibung der Zeichnungen

Es zeigen:
- FIG 1: eine Schnittdarstellung einer ersten Ausführungsform eines erfindungsgemässen Leistungshalbleiter-Moduls;
- FIG 2: eine Schnittdarstellung einer weiteren Ausführungsform eines erfindungsgemässen Leistungshalbleiter-Moduls; und
- FIG 3: eine Schnittdarstellung einer weiteren Ausführungsform eines erfindungsgemässen Leistungshalbleiter-Moduls.

Die in den Zeichnungen verwendeten Bezugszeichen sind in der Bezugszeichenliste zusammengefasst aufgelistet. Grundsätzlich sind in den Zeichnungen gleiche Teile mit gleichen Bezugszeichen versehen. Die beschriebenen Ausführungsformen stehen beispielhaft für den Erfindungsgegenstand und haben keine beschränkende Wirkung.

### Wege zur Ausführung der Erfindung

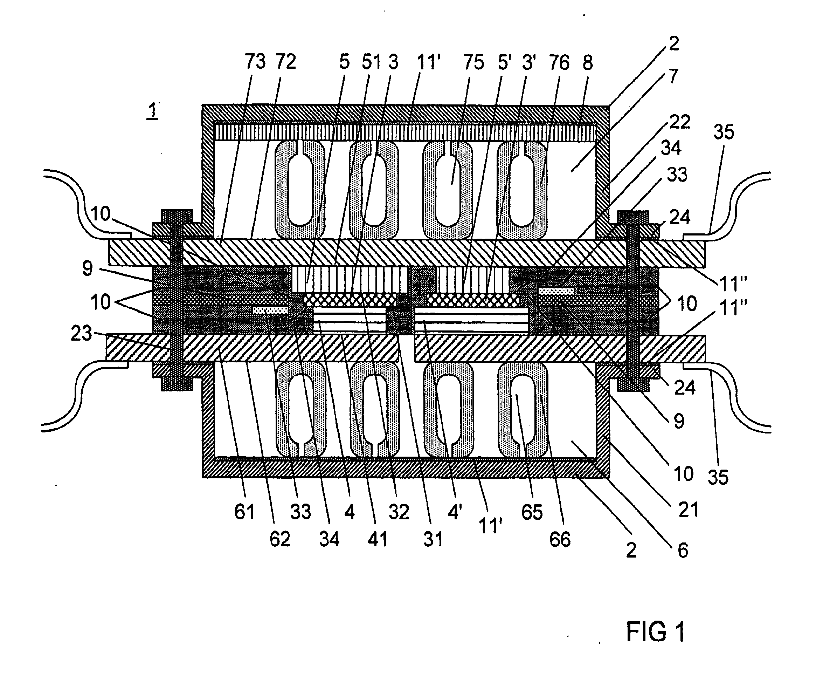

In FIG 1 ist eine Schnittdarstellung einer ersten Ausführungsform eines erfindungsgemässen Leistungshalbleiter-Moduls dargestellt. Das erfindungsgemässe Leistungshalbleitermodul 1 weist gemäss FIG 1 ein Gehäuse 2 mit einem ersten Gehäuseteil 21 und einem zweiten Gehäuseteil 22 auf, in dem mindestens ein Halbleiterchip 3, 3' angeordnet ist. Der mindestens eine Halbleiterchip 3, 3' weist jeweils eine erste Hauptelektrodenseite 31 und eine der ersten Hauptelektrodenseite gegenüberliegende zweite Hauptelektrodenseite 32 auf. Die erste Hauptelektrodenseite 31 ist thermisch und elektrisch mit einer ersten Grundplatte 4, 4' kontaktiert. Eine erste Kühlvorrichtung 6 ist mit der der ersten Hauptelektrodenseite abgewandten Seite der ersten Grundplatte 41 thermisch kontaktiert. Die zweite Hauptelektrodenseite 32 ist thermisch und elektrisch mit einer zweiten Grundplatte 5, 5' kontaktiert. Eine zweite Kühlvorrichtung 7 ist mit der der zweiten Hauptelektrodenseite abgewandten Seite der zweiten Grundplatte 51 thermisch kontaktiert.

Es können unterschiedliche Typen von Halbleiterchips 3, 3' wie Gleichrichterdioden oder Freilaufdioden, Schalter wie IGBTs (Insulated Gate Bipolar Transistor), FETs (Feldeffekt-Transistor), BTs (Bipolar-Transistor), eine Kombination von einer Diode mit einem Schalter oder rückwärts sperrende Schalter eingesetzt werden.

Eine elektrische Kontaktierung kann vorzugsweise durch eine stoffschlüssige Verbindung wie eine Lötverbindung erreicht werden, aber auch als Druckkontakt ausgeführt sein. Thermische Kontaktierungen werden ebenfalls vorzugsweise mit einer Lötverbindung oder als Druckkontakt mit Wärmeleitpaste erreicht.

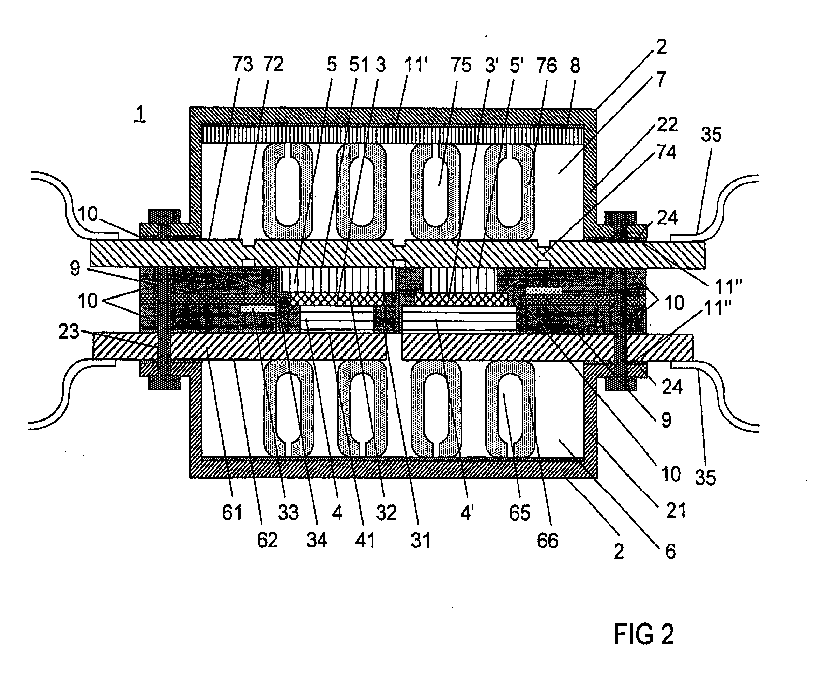

Gemäss FIG 1 umfasst die erste Kühlvorrichtung 6 ein erstes Hauptelektrodenanschlusselement 61, welches mit der der ersten Hauptelektrodenseite abgewandten Seite der ersten Grundplatte 41 thermisch und elektrisch kontaktiert ist. Die zweite Kühlvorrichtung 7 umfasst ein zweites Hauptelektrodenanschlusselement, welches mit der der zweiten Hauptelektrodenseite abgewandten Seite der zweiten Grundplatte 51 ebenfalls thermisch und elektrisch kontaktiert ist. In FIG 1 ist das zweite Hauptelektrodenanschlusselement als eine zweite Hauptelektrodenanschlussplatte 73 ausgebildet, welche mindestens zwei Halbleiterchips 3, 3' thermisch und elektrisch kontaktiert. Weitere Alternativen hierzu werden in Ausführungsformen zu FIG 2 beschrieben. Die ersten Hauptelektrodenanschlusselemente 61 und die zweiten Hauptelektrodenanschlusselemente sind sowohl thermisch wie auch elektrisch mit den Halbleiterchips 3, 3' kontaktiert, so dass der Aufbau des Leistungshalbleiter-Moduls 1 einfach ist. Die ersten und zweiten Hauptelektrodenanschlusselemente werden durch äussere Anschlussleiter 35 kontaktiert. Zwischen den ersten und zweiten Hauptelektrodenanschlusselementen und dem mindestens einen Halbleiterchip 3, 3' sind keine elektrisch isolierenden Schichten notwendig, durch die der Wärmeabtransport beeinträchtigt wird. Da der Leistungsstrom nicht durch Drähte, sondern durch die Grundplatten 4, 4', 5, 5' und die ersten und zweiten Hauptelektrodenanschlusselemente 61 fliesst, ist die Impedanz für die Kontaktierungen klein und somit ist das Leistungshalbleiter-Modul 1 für den Hochleistungsbereich geeignet.

Zur Vermeidung unerwünschter Ströme ist ein Isolator 10 zwischen den ersten und zweiten Hauptelektrodenanschlusselementen 61 und im Falle mehrere Halbleiterchips 3, 3' zwischen benachbarten Halbleiterchips 3, 3' angeordnet. Der Isolator kann einstückig oder mehrstückig ausgebildet sein. Der Ausdehnungskoeffizient des Isolators 10 ist vorteilhafterweise dem des Halbleiterchips 3, 3' angepasst. Der Isolator 10 kann beispielsweise aus einem gefüllten Epoxidharz mit inorganischem Füllmaterial bestehen.

Die erste Kühlvorrichtung 6 umfasst gemäss FIG 1 einen Kühlkörper 65, welcher mit der der ersten Hauptelektrodenseite abgewandten Seite des ersten Hauptelektrodenanschlusselements 62 thermisch kontaktiert ist. Durch den Kühlkörper 65 können zusätzlich Kühlfluids wie Kühlflüssigkeiten oder Gase, insbesondere Luft durchgeleitet werden, um eine grosse Wärmemenge schnell abzuführen. Um einen guten thermischen Übergang zu schaffen, kann eine Wärmeleitpaste zwischen dem Kühlkörper 65 und dem ersten Hauptelektrodenanschlusselement 61 angebracht werden. Alternativ kann der Kühlkörper 65 auch mittels einer Lötverbindung thermisch mit dem ersten Hauptelektrodenanschlusselement 61 verbunden sein. Es ist ebenfalls denkbar, den Kühlkörper 65 und das erste Hauptelektrodenanschlusselement 61 aus einem Stück zu fertigen, beispielsweise aus einem stranggepressten Aluminiumprofil, so dass ein thermischer Übergang zwischen dem Kühlkörper 65 und dem ersten Hauptelektrodenanschlusselement 61 entfällt. Durch einen derartig einstückig ausgebildeten Kühlkörper 65 und erstes Hauptelektrodenanschlusselement 61 ist die in dem mindestens einen Halbleiterchip 3, 3' entstehende Wärme effizient abführbar, weil Kontaktflächen, welche den Wärmeübergang verschlechtern könnten, entfallen.

Die zweite Kühlvorrichtung 7 umfasst einen Kühlkörper 75, welcher mit der der zweiten Hauptelektrodenseite abgewandten Seite des zweiten Hauptelektrodenanschlusselements 72 thermisch kontaktiert ist. Durch den Kühlkörper 75 können zusätzlich Kühlfluids wie Kühlflüssigkeiten oder Gase, insbesondere Luft durchgeleitet werden, um eine grosse Wärmemenge schnell abzuführen. Um einen guten thermischen Übergang zu schaffen, kann eine Wärmeleitpaste zwischen dem Kühlkörper 75 und der zweiten Hauptelektrodenanschlussplatte 73t angebracht werden. Alternativ kann der Kühlkörper 75 auch mittels einer Lötverbindung thermisch mit der zweiten Hauptelektrodenanschlussplatte 73 verbunden sein. Es ist ebenfalls denkbar, den Kühlkörper 75 und die zweite Hauptelektrodenanschlussplatte 73 aus einem Stück zu fertigen, beispielsweise aus einem stranggepressten Aluminiumprofil, so dass ein thermischer Übergang zwischen dem Kühlkörper 75 und dem zweiten Hauptelektrodenanschlusselement entfällt. Durch einen derartig einstückig ausgebildeten Kühlkörper 75 und zweites Hauptelektrodenanschlusselement ist die in dem mindestens einen Halbleiterchip 3, 3' entstehende Wärme effizient abführbar, weil Kontaktflächen, welche den Wärmeübergang verschlechtern könnten, entfallen.. Der Kühlkörper 75 kann neben der thermischen Kontaktierung auch elektrisch mit dem zweiten Hauptelektrodenanschlusselement kontaktiert sein. In dem Fall sind keine den thermischen Übergang verschlechternden elektrisch isolierenden Elemente zwischen dem mindestens einen Halbleiterchip 3, 3' und dem Kühlkörper 75 angeordnet, welche den thermischen Übergang verschlechtern. Alternativ ist der Kühlkörper 75 der zweiten Kühlvorrichtung 7 elektrisch gegenüber dem zweiten Hauptelektrodenanschlusselement isoliert. In diesem Fall braucht der Kühlkörper 75 nicht gegenüber der Umgebung isoliert zu werden. In einer Variante gemäss FIG 1 ist es möglich, dass beide Kühlvorrichtungen 6, 7 Kühlkörper 65, 75 umfassen, so dass eine sehr grosse Wärmemenge schnell von dem mindestens einen Halbleiterchip 3, 3' abführbar ist.

Mindestens ein Kühlkörper 65, 75 stützt sich, wie in FIG 1 dargestellt, gegen das Gehäuse 2 ab. Durch das Abstützen des mindestens einen Kühlkörpers 65, 75 gegen das Gehäuse 2 wird das Halbleiter-Modul 1 mechanisch stabil, beispielsweise gegen Stösse und Vibrationen.

In FIG. 1 ist der Kühlkörper 65 neben der thermischen Kontaktierung auch elektrisch mit dem ersten Hauptelektrodenanschlusselement 61 kontaktiert. In diesem Fall sind keine den thermischen Übergang verschlechternde elektrisch isolierenden Elemente zwischen dem mindestens einen Halbleiterchip 3, 3' und dem Kühlkörper 65 der ersten Kühlvorrichtung 6 angeordnet. Ebenso ist der Kühlkörper 75 neben der thermischen Kontaktierung auch elektrisch mit der zweiten Hauptelektrodenanschlussplatte 73 kontaktiert. Die Kühlkörper 65, 75 sind durch Isolatoren 11' und 11" gegenüber dem Gehäuse 2 isoliert, wobei der Isolator 11' zwischen dem Kühlkörper 65, 75 der ersten, bzw. zweiten Kühlvorrichtung .6, 7 und dem Gehäuse 2 angeordnet ist und der Isolator 11" zwischen dem ersten Hauptelektrodenanschlusselement 61, bzw. der zweiten Hauptelektrodenanschlussplatte 73 und dem Gehäuse 2 angeordnet ist.

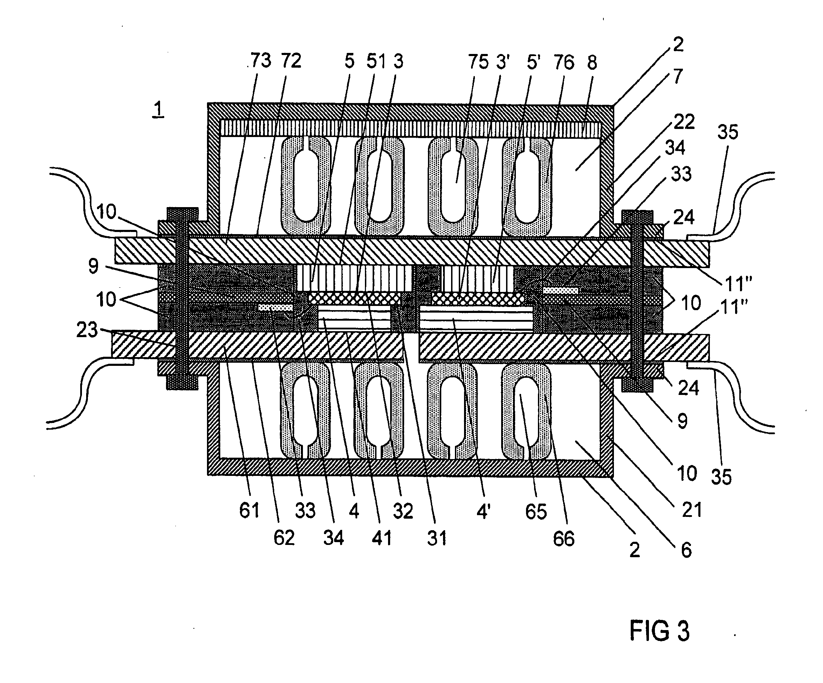

In FIG. 3 ist eine weitere Ausführungsform des erfinderischen Gegenstands gezeigt, in dem der Kühlkörper 65 der ersten Kühlvorrichtung 6 elektrisch gegenüber dem ersten Hauptelektrodenanschlusselement 61 isoliert ist, in FIG 3 durch einen Isolator 11 gezeigt. In diesem Fall braucht der Kühlkörper nicht gegenüber der Umgebung elektrisch isoliert zu werden. Ebenso ist der Kühlkörper 75 der zweiten Kühlvorrichtung 7 elektrisch gegenüber der zweiten Hauptelektrodenanschlussplatte 73 isoliert, in FIG 3 durch den Isolator 11 gezeigt. Alternativ ist es auch möglich, dass das erste Hauptelektrodenanschlusselement 61 gegenüber dem Kühlkörper 65 der ersten Kühlvorrichtung 6 und der Kühlkörper 75 der zweiten Kühlvorrichtung 7 isoliert gegenüber dem Gehäuse 2 ist oder umgekehrt. Entscheidend dabei ist lediglich, dass das erste Hauptelektrodenanschlusselement 61 und die zweite Hauptelektrodenanschlussplatte 73 isoliert von dem Gehäuse 2 angeordnet sind.

Die Isolatoren 11, 11' und/oder 11" können beispielsweise eine Platte aus isolierendem Material wie Kunststoff sein. Mit solchen Isolationen wird das Halbleiter-Modul 1 gegenüber der Umgebung isoliert und der Einbau eines solchen Halbleiter-Moduls 1 beispielsweise in einen Umrichter einfach.

Vorteilhaft ist, wenn der Kühlkörper 65 der ersten Kühlvorrichtung 6, wie in FIG 1 dargestellt, Kühlrippen 66 umfasst, so dass der Kühlkörper 65 eine grosse Oberfläche aufweist, über welche eine grosse Wärmemenge gut abführbar ist. Es ist auch denkbar, dass der Kühlkörper 75 der zweiten Kühlvorrichtung 7, wie in FIG 1 dargestellt, Kühlrippen 76 umfasst, so dass der Kühlkörper 75 eine grosse Oberfläche aufweist, über welche eine grosse Wärmemenge gut abführbar ist. Es ist auch denkbar, dass die Kühlkörper 65, 75 beider Kühlvorrichtungen 6, 7 Kühlrippen 66, 76 aufweisen.

In dem Fall, dass mindestens einer der Kühlkörper 65, 75 Kühlrippen 66, 76 aufweist, kann das Gehäuse 2 zumindest teilweise offen sein, so dass Luft entlang der Kühlrippen 66, 76 strömbar ist. Damit kann Wärme von den Kühlrippen 66, 76 abgeführt werden.

In einer weiteren bevorzugten Ausführungsform des erfindungsgemässen Gegenstands gemäss FIG 1 umfasst das Gehäuse 2 ein erstes Gehäuseteil 21 und ein zweites Gehäuseteil 22. Der mindestens eine Halbleiterchip 3, 3' ist mit seiner ersten Hauptelektrodenseite 31 zumindest teilweise von dem ersten Gehäuseteil 21 und mit seiner zweiten Hauptelektrodenseite 32 zumindest teilweise von dem zweiten Gehäuseteil 22 umgeben. In einer Variante ist zwischen der ersten Kühlvorrichtung 6 und dem ersten Gehäuseteil 21 ein flexibles und zusammenpressbares Element 8 angeordnet. In einer anderen Variante ist ein flexibles und zusammenpressbares Element 8 zwischen der zweiten Kühlvorrichtung 7 und dem zweiten Gehäuseteil 22 angeordnet oder es sind zwischen jeder Kühlvorrichtung 6, 7 und dem jeweiligen Gehäuseteil 21, 22 flexible und zusammenpressbare Elemente 8 angeordnet. Das flexible und zusammenpressbare Element 8 kann ein Federelement aus Schaumstoff oder ein Gummi sein. Als Federelement ist insbesondere auch ein Elastomer-, Polymer-, Kunststoff-, Metall- oder Gasdruckfederelement geeignet. Durch das flexible und zusammendrückbare Element 8 sind die zwei Gehäuseteile 21, 22 mit den in den Gehäuseteilen 21, 22 befindlichen Bauteilen zusammenpressbar. Die Gehäuseteile 21, 22 weisen Ansatzstücke 24 auf, zwischen denen die ersten und zweiten Hauptelektrodenanschlusselemente nach draussen geführt werden. An diesen Ansatzstücken 24 sind Fixiermittel 23 angeordnet, mit denen die Lage der in den Gehäuseteilen 21, 22 befindlichen zusammengepressten Bauteile fixiert werden kann. Die Fixiermittel 24 können Schrauben, Klemmen, Spannverschlüsse oder andere, zu diesem Zweck geeignete Elemente sein. Ein solches Halbleiter-Modul 1 ist robust gegen mechanische Einflüsse wie Stösse und Vibrationen. Da die Bauteile in dem Gehäuse 2 dauerhaft und unter Druck zusammengepresst sind, ist ein guter thermischer und elektrischer Übergang zwischen den in dem Gehäuse 2 befindlichen Bauteilen gewährleistet. Das flexible und zusammenpressbare Element 8 braucht nicht elektrisch leitend zu sein und ist keinen hohen Temperaturen ausgesetzt, da zumindest ein hoher Anteil der von dem mindestens einem Halbleiterchip 3, 3' erzeugte Wärme von den Kühlkörpern 65, 75 abgeleitet wird. Eine Vielzahl von flexiblen und kostengünstigen Materialien steht daher für das flexible Element 8 zur Auswahl.

In einer bevorzugten Ausführungsform ist das flexible und zusammenpressbare Element 8 selbst elektrisch isolierend, so dass kein zusätzlicher Isolator zwischen dem Kühlkörper 65, 75 und dem Gehäuse 2 erforderlich ist.

Im Falle von mehreren Halbleiterchips 3, 3' ist es möglich, dass jeweils die auf einer ersten und/oder zweiten Grundplatte 4,4', 5, 5' angeordneten Halbleiterchips 3 gemeinsam durch ein flexibles und zusammenpressbares Element 8 zusammenpressbar sind. Damit wird mechanisch separiert jeweils auf einzelne Grundplatten 4, 4' und/oder 5, 5' Druck ausgeübt, so dass eine gute thermische und/oder elektrische Kontaktierung erzielt wird.

Alternativ zu dem flexiblen und zusammenpressbaren Element 8 ist es auch denkbar, die Kühlrippen 66 und / oder die Kühlrippen 76 selber federnd auszubilden. Dies kann beispielsweise durch eine konkave, konvexe oder wellenförmige Ausformung der Kühlrippen 66, 76 erzielt werden. Ebenso ist es alternativ denkbar, dass im Falle eines zweiteilig ausgebildeten Gehäuses 2 das erste und / oder zweite Gehäuseteil 21, 22 federnd ausgebildet ist. Dies kann beispielsweise durch eine konkave, konvexe oder wellenförmige Ausformung des ersten und / oder zweiten Gehäuseteils 21, 22 in den Bereichen, welche eine Federkraft ausüben kann, welche senkrecht zu den Hauptelektrodenseiten 31, 32 wirkt oder welche zumindest eine senkrecht zu den Hauptelektrodenseiten 31,32 wirkende Federkraftkomponente aufweist. Auch im Falle eines einteilig ausgebildeten Gehäuses 2 kann dieses federnd ausgebildet sein.

Der mindestens eine Halbleiterchip 3, 3' kann gemäss FIG 1 einen Steueranschluss 33 aufweisen, welcher parallel bezüglich der ersten oder der zweiten Hauptelektrodenseite 31, 32 des zugehörigen Halbleiterchips 3, 3' wegführt. Der Steueranschluss 33 kann über einen Bonddraht 34 elektrisch mit einer Leiterplatte 9, welche im Bereich der Ebene des mindestens einen Halbleiterchips 3, 3' angeordnet ist, kontaktiert sein. Alternativ kann der Steueranschluss 33 gestanzte Anschlussbeinchen aufweisen, die kostengünstig herstellbar sind und auf einfache Weise auf die Leiterplatte 9 gesteckt oder auf der Leiterplatte 9 festgelötet werden können. Die Leiterplatte ist gegenüber den ersten und zweiten Hauptelektrodenanschlusselementen 61 und dem mindestens einen Halbleiterchip 3, 3' elektrisch isoliert. Mit einer solchen Leiterplatte 9 lässt sich ein kompaktes Halbleiter-Modul 1 mit einfacher Verdrahtung aufbauen. Der Übersichtlichkeit halber ist nicht dargestellt, dass der mindestens eine Halbleiterchip 3, 3' als Variante Steueranschlüsse mit gestanzten Anschlussbeinchen aufweist. Wenn jede Hauptelektrodenseite 31, 32 durch je einen elektrischen Kontakt mit je einem Steueranschluss verbunden wird, können diese Steueranschlüsse dazu benutzt werden, um die Halbleiterchips 3, 3' vor dem Einbau in das Halbleiter-Modul 1 auf einfache Weise zu testen und sie können zur Ansteuerung des Halbleiterchips 3, 3' dienen. Der mindestens eine Halbleiterchip 3, 3' kann auch mehr als einen Steueranschluss 33 aufweisen.

In FIG 2 ist eine weitere bevorzugte Ausführungsform des Halbleiter-Moduls 1 dargestellt, in der das Halbleiter-Modul 1 mindestens zwei Halbleiterchips 3, 3' und mindestens zwei erste und zwei zweite Grundplatten 4, 4', 5, 5' aufweist, wobei mindestens jeweils ein Halbleiterchip 3, 3' auf seinen Hauptelektrodenseiten 31, 32 mit einer ersten und zweiten Grundplatte 4, 4', 5, 5' thermisch und elektrisch kontaktiert ist. Die jeweiligen ersten Hauptelektrodenanschlusselemente 61 sind miteinander elektrisch kontaktiert oder als ein gemeinsames erstes Hauptelektrodenanschlusselement ausgebildet. Die jeweiligen zweiten Hauptelektrodenanschlusselemente können ebenfalls miteinander elektrisch kontaktiert oder als ein gemeinsames zweites Hauptelektrodenanschlusselement ausgebildet sein. In Fällen, in denen mehrere Halbleiterchips auf demselben Potential liegen, lassen sich in einer derartigen Anordnung kompakte HalbleiterModule mit einem einfachen Aufbau schaffen, die zudem einfach herstellbar sind.

Es ist sowohl denkbar, dass mindestens ein zwischen einer ersten und Grundplatte 4, 5 angeordneter Halbleiterchip 3 mit mindestens einem zweiten, zwischen einer weiteren ersten und zweiten Grundplatte 4', 5' angeordneten Halbleiterchip 3 parallel oder antiparallel geschaltet ist. In FIG 2 ist die erste Grundplatte 4 der Emitter und die zugehörige zweite Grundplatte 5 der Kollektor für den zwischen den beiden Grundplatten 4, 5 angeordneten Halbleiterchip 3. Ein weiterer Halbleiterchip 3' ist zwischen einer ersten und zweiten Grundplatte 4', 5' angeordnet, wobei die erste Grundplatte 4' hier der Kollektor und die zweite Grundplatte 5' der Emitter für den zwischen beiden Grundplatten 4', 5' angeordneten Halbleiterchip 3' ist. Es ist auch denkbar, dass das Halbleiter-Modul 1 mehrere solcher Chip-Anordnungen von mindestens einem Halbleiterchip 3, 3' zwischen einer ersten und zweiten Grundplatte 4, 4', 5, 5' aufweist, wobei die Halbleiter 3, 3' eines Teils der Chip-Anordnungen parallel und ein anderer Teil antiparallel geschaltet sind, d.h. dass ein Teil der auf der ersten Hauptelektrodenseite 31 angeordneten Grundplatten 4, 4' als Kollektor wirkt und ein anderer Teil als Emitter. Die jeweils über einen Halbleiterchip 3, 3' mit einer ersten, als Emitter wirkenden Grundplatte 4, 4' verbundenen zweiten Grundplatten 5, 5' wirken als Kollektor und umgekehrt. So ist es beispielsweise möglich, zwei benachbart angeordnete Chip-Anordnungen antiparallel zu verschalten und senkrecht dazu in derselben Ebene angeordnete Chip-Anordnungen jeweils zu den anderen, in derselben Reihe angeordneten Chip-Anordnungen parallel zu schalten, so dass man zwei Reihen von Chip-Anordnungen erhält, wobei in einer ersten Reihe auf der ersten Hauptelektrodenseite 31 nur als Emitter wirkende erste Grundplatten 4 angeordnet sind und auf der zweiten Hauptelektrodenseite 32 nur als Kollektor wirkende zweite Grundplatten 5 angeordnet sind. In der zweiten, zur ersten Reihe parallel liegenden Reihe sind auf der ersten Hauptelektrodenseite 31 nur als Kollektor wirkende erste Grundplatten 4' angeordnet sind und auf der zweiten Hauptelektrodenseite 32 nur als Emitter wirkende zweite Grundplatten 5' angeordnet.

In einer weiteren bevorzugten Ausführungsform des erfindungsgemässen Gegenstands ist mindestens ein zwischen einer ersten und zweiten Grundplatte (4, 5) angeordneter Halbleiterchip (3) mit mindestens einem zweiten, zwischen einer weiteren ersten und zweiten Grundplatte (4', 5') angeordneten Halbleiterchip (3') in Serie geschaltet.

Im Falle eines gemeinsamen ersten Hauptelektrodenanschlusselements kann das gemeinsame erste Hauptelektrodenanschlusselement als eine erste Hauptelektrodenanschlussplatte ausgebildet sein. Dies ist der Übersichtlichkeit halber nicht in einer Figur dargestellt. Zwischen den Bereichen, in denen die mindestens zwei Halbleiterchips 3, 3' kontaktiert sind, weist die erste Hauptelektrodenanschlussplatte Verjüngungen auf. Im Falle eines gemeinsamen zweiten Hauptelektrodenanschlusselements kann das gemeinsame zweite Hauptelektrodenanschlusselement wie in FIG 2 dargestellt als eine zweite Hauptelektrodenanschlussplatte 73 ausgebildet sein. Zwischen den Bereichen, in denen die mindestens zwei Halbleiterchips 3, 3' kontaktiert sind, weist die zweite Hauptelektrodenanschlussplatte 73 Verjüngungen 74 auf. Es ist auch denkbar, in dem Leistungshalbleiter-Modul 1 eine erste gemeinsame Hauptelektrodenanschlussplatte mit Verjüngungen und eine zweite gemeinsame Hauptelektrodenanschlussplatte 73 mit Verjüngungen 74 vorzusehen. Durch derartige Verjüngungen 74 lassen sich Höhenunterschiede zwischen den Halbleiterchips 3, 3' oder unterschiedliche Ausdehnungen in den Halbleiterchips 3, 3' und der ersten und / oder zweiten Grundplatte 4, 4', 5, 5' bei Erwärmung ausgleichen. Eine solche erste und / oder zweite Hauptelektrodenanschlussplatte 73 mit Verjüngungen 74 ist vorteilhaft in Verbindung mit dem flexiblen und zusammenpressbaren Element 8 verwendbar, weil sowohl die erste und / oder zweite Hauptelektrodenanschlussplatte 73 mit Verjüngungen 74 als auch das flexible und zusammenpressbare Element 8 es ermöglicht, Höhenunterschiede zwischen den einzelnen Halbleiterchips 3, 3' auszugleichen oder unterschiedliche Ausdehnungen in den Halbleiterchips 3, 3' und der ersten und / oder zweiten Grundplatte 4, 4', 5, 5' bei Erwärmung ausgleichen.

### Bezugszeichenliste

- 1: Leistungshalbleiter-Modul
- 2: Gehäuse
- 21: erstes Gehäuseteil
- 22: zweites Gehäuseteil
- 23: Fixiermittel
- 24: Ansatzstück
- 3, 3': Halbleiterchip
- 31: erste Hauptelektrodenseite
- 32: zweite Hauptelektrodenseite
- 33: Steueranschluss
- 34: Bonddraht
- 35: Anschlussleiter
- 4, 4': erste Grundplatte
- 41: der ersten Hauptelektrodenseite abgewandte Seite der ersten Grundplatte
- 5, 5': zweite Grundplatte
- 51: der zweiten Hauptelektrodenseite abgewandte Seite der zweiten Grundplatte
- 6: erste Kühlvorrichtung
- 61: erstes Hauptelektrodenanschlusselement
- 62: der ersten Hauptelektrodenseite abgewandte Seite des ersten Hauptelektrodenanschlusselements
- 65: Kühlkörper
- 66: Kühlrippe
- 7: zweite Kühlvorrichtung
- 72: der zweiten Hauptelektrodenseite abgewandte Seite des zweiten Hauptelektrodenanschlusselements
- 73: zweite Hauptelektrodenanschlussplatte
- 74: Verjüngung
- 75: Kühlkörper
- 76: Kühlrippe
- 8: flexibles und zusammenpressbares Element
- 9: Leiterplatte
- 10: Isolator
- 11, 11', 11": Isolator

## Patentansprüche

1. Leistungshalbleiter-Modul (1), umfassend
- mindestens zwei Halbleiterchips (3, 3') und mindestens zwei erste und zwei zweite Grundplatten (4, 4', 5, 5'), welche mindestens zwei Halbleiterchips (3, 3') jeweils eine erste Hauptelektrodenseite (31) und eine der ersten Hauptelektrodenseite gegenüberliegende zweite Hauptelektrodenseite (32) aufweisen, wobei jeweils die erste Hauptelektrodenseite (31) thermisch und elektrisch mit der jeweiligen ersten Grundplatte (4, 4') kontaktiert ist und jeweils die zweite Hauptelektrodenseite (32) thermisch und elektrisch mit der jeweiligen zweiten Grundplatte (5, 5') kontaktiert ist,
- eine erste Kühlvorrichtung (6) mit mindestens zwei ersten Hauptelektrodenanschlusselementen (61) und einem Kühlkörper (65), wobei jeweils ein erstes Hauptelektrodenanschlusselement (61) mit der der ersten Hauptelektrodenseite abgewandten Seite einer ersten Grundplatte (41) thermisch und elektrisch kontaktiert ist und wobei der Kühlkörper (65) jeweils mit der der ersten Hauptelektrodenseite abgewandten Seite des ersten Hauptelektrodenanschlusselements (62) thermisch kontaktiert ist,
- eine zweite Kühlvorrichtung (7), welche mit der der zweiten Hauptelektrodenseite abgewandten Seite der jeweiligen zweiten Grundplatten (51) thermisch kontaktiert ist, wobei die zweite Kühlvorrichtung (7) mindestens zwei zweite Hauptelektrodenanschlusselemente aufweist, wobei jeweils ein zweites Hauptelektrodenanschlusselement mit der der zweiten Hauptelektrodenseite abgewandten Seite einer zweiten Grundplatte (51) thermisch und elektrisch kontaktiert ist, wobei die jeweiligen zweiten Hauptelektrodenanschlusselemente miteinander elektrisch kontaktiert sind oder die jeweiligen zweiten Hauptelektrodenanschlusselemente gemeinsames als ein zweites Hauptelektrodenanschlusselement ausgebildet sind,
und wobei das Leistungshalbleitermodul (1) ein Gehäuse umfasst, in welchem die mindestens zwei Halbleiterchips (3, 3') und die erste und zweite Kühlvorrichtung (6, 7) angeordnet sind
und wobei der Kühlkörper (65) der ersten Kühlvorrichtung (6) sich auf der Seite, welche den ersten Hauptelektrodenanschlusselementen (61) gegenüber liegt, gegen das Gehäuse (2) abstützt.

2. Leistungshalbleiter-Modul nach Anspruch 1, **dadurch gekennzeichnet, dass** die ersten Hauptelektrodenanschlusselemente (61) elektrisch gegenüber dem Gehäuse (2) isoliert sind.

3. Leistungshalbleiter-Modul nach Anspruch 1 oder 2, **dadurch gekennzeichnet, dass** der Kühlkörper (65) der ersten Kühlvorrichtung (6) elektrisch gegenüber dem Gehäuse (2) isoliert ist.

4. Leistungshalbleiter-Modul nach Anspruch 2 oder 3, **dadurch gekennzeichnet, dass**
der Kühlkörper (65) der ersten Kühlvorrichtung (6) elektrisch mit den ersten Hauptelektrodenanschlusselementen (61) kontaktiert ist.

5. Leistungshalbleiter-Modul nach einem der Ansprüche 1 bis 3, **dadurch gekennzeichnet, dass**
der Kühlkörper (65) der ersten Kühlvorrichtung (6) elektrisch gegenüber den ersten Hauptelektrodenanschlusselementen (61) isoliert ist.

6. Leistungshalbleiter-Modul nach einem der Ansprüche 1 bis 5, **dadurch gekennzeichnet, dass** der Kühlkörper (65) der ersten Kühlvorrichtung (6) Kühlrippen (66) aufweist.

7. Leistungshalbleiter-Modul nach einem der Ansprüche 1 bis 6, **dadurch gekennzeichnet, dass** die zweite Kühlvorrichtung (7) einen Kühlkörper (75) umfasst, welcher mit der der zweiten Hauptelektrodenseite abgewandten Seite des jeweiligen zweiten Hauptelektrodenanschlusselements (72) thermisch kontaktiert ist.

8. Leistungshalbleiter-Modul nach Anspruch 7, **dadurch gekennzeichnet, dass** der Kühlkörper (75) der zweiten Kühlvorrichtung (7) sich auf der Seite, welche den zweiten Hauptelektrodenanschlusselementen gegenüber liegt, gegen das Gehäuse (2) abstützt.

9. Leistungshalbleiter-Modul nach Anspruch 7 oder 8, **dadurch gekennzeichnet, dass** die zweiten Hauptelektrodenanschlusselemente elektrisch gegenüber dem Gehäuse (2) isoliert sind.

10. Leistungshalbleiter-Modul nach einem der Ansprüche 7 bis 9, **dadurch gekennzeichnet, dass** der Kühlkörper (75) der zweiten Kühlvorrichtung (7) elektrisch gegenüber dem Gehäuse (2) isoliert ist.

11. Leistungshalbleiter-Modul nach Anspruch 9 oder 10, **dadurch gekennzeichnet, dass**
der Kühlkörper (75) der zweiten Kühlvorrichtung (7) elektrisch mit den zweiten Hauptelektrodenanschlusselementen kontaktiert ist.

12. Leistungshalbleiter-Modul nach einem der Ansprüche 7 bis 10, **dadurch gekennzeichnet, dass**
der Kühlkörper (75) der zweiten Kühlvorrichtung (7) elektrisch gegenüber den zweiten Hauptelektrodenanschlusselementen isoliert ist.

13. Leistungshalbleiter-Modul nach einem der Ansprüche 7 bis 12, **dadurch gekennzeichnet, dass** der Kühlkörper (75) der zweiten Kühlvorrichtung (7) Kühlrippen (76) aufweist.

14. Leistungshalbleiter-Modul nach einem der vorangegangenen Ansprüche, **dadurch gekennzeichnet, dass**
die jeweiligen ersten Hauptelektrodenanschlusselemente miteinander elektrisch kontaktiert sind oder
die jeweiligen ersten Hauptelektrodenanschlusselemente als ein gemeinsames erstes Hauptelektrodenanschlusselement ausgebildet sind.

15. Leistungshalbleiter-Modul nach Anspruch 14 **dadurch gekennzeichnet, dass**
im Falle eines gemeinsamen ersten Hauptelektrodenanschlusselements das gemeinsame erste Hauptelektrodenanschlusselement als Hauptelektrodenanschlussplatte ausgebildet ist, welche Verjüngungen zwischen den Bereichen aufweist, in denen die mindestens zwei
Halbleiterchips (3, 3') kontaktiert sind.

16. Leistungshalbleiter-Modul nach einem der vorangegangenen Ansprüche, **dadurch gekennzeichnet, dass**
im Falle eines gemeinsamen zweiten Hauptelektrodenanschlusselements das gemeinsame zweite Hauptelektrodenanschlusselement als Hauptelektrodenanschlussplatte (73) ausgebildet ist, welche Verjüngungen (74) zwischen den Bereichen aufweist, in denen die mindestens zwei Halbleiterchips (3, 3') kontaktiert sind.

17. Leistungshalbleiter-Modul nach einem der vorangegangenen Ansprüche, **dadurch gekennzeichnet, dass**
mindestens ein zwischen einer ersten und zweiten Grundplatte (4, 5) angeordneter Halbleiterchip (3) mit mindestens einem zweiten, zwischen einer weiteren ersten und zweiten Grundplatte (4', 5') angeordneten Halbleiterchip (3') parallel geschaltet ist.

18. Leistungshalbleiter-Modul nach einem der Ansprüche1 bis 16, **dadurch gekennzeichnet, dass**
mindestens ein zwischen einer ersten und zweiten Grundplatte (4, 5) angeordneter Halbleiterchip (3) mit mindestens einem zweiten, zwischen einer weiteren ersten und zweiten Grundplatte (4', 5') angeordneten Halbleiterchip (3') antiparallel geschaltet ist.

19. Leistungshalbleiter-Modul nach einem der Ansprüche 1 bis 18, **dadurch gekennzeichnet, dass**
mindestens ein zwischen einer ersten und zweiten Grundplatte (4, 5) angeordneter Halbleiterchip (3) mit mindestens einem zweiten, zwischen einer weiteren ersten und zweiten Grundplatte (4', 5') angeordneten Halbleiterchip (3') in Serie geschaltet ist.

20. Leistungshalbleiter-Modul nach einem der vorangegangenen Ansprüche, **dadurch gekennzeichnet, dass** das Gehäuse (2) ein erstes Gehäuseteil (21) und ein zweites Gehäuseteil (22) umfasst, wobei die mindestens zwei Halbleiterchips (3, 3') mit ihren ersten und ihren zweiten Hauptelektrodenseiten (31, 32) zumindest teilweise von je einem Gehäuseteil (21, 22) umgeben sind, und dass
ein flexibles und zusammenpressbares Element (8) zwischen der ersten Kühlvorrichtung (6) und dem ersten Gehäuseteil (21) angeordnet ist.

21. Leistungshalbleiter-Modul nach einem der vorangegangenen Ansprüche, **dadurch gekennzeichnet, dass** das Gehäuse (2) ein erstes Gehäuseteil (21) und ein zweites Gehäuseteil (22) umfasst, wobei die mindestens zwei Halbleiterchips (3, 3') mit ihrer ersten und ihrer zweiten Hauptelektrodenseite (31, 32) zumindest teilweise von je einem Gehäuseteil (21, 22) umgeben sind, und dass
ein flexibles und zusammenpressbares Element (8) zwischen der zweiten Kühlvorrichtung (7) und dem zweiten Gehäuseteil (22) angeordnet ist.

22. Leistungshalbleiter-Modul nach einem der Ansprüche 20 oder 21, **dadurch gekennzeichnet, dass** das flexible und zusammenpressbare Element (8) ein Federelement, insbesondere ein Elastomer-, Polymer-, Kunststoff-, Metall- oder Gasdruckfederelement ist.

23. Leistungshalbleiter-Modul nach einem der Ansprüche 1 bis 19, **dadurch gekennzeichnet, dass** das Gehäuse (2) einteilig ausgebildet ist.

24. Leistungshalbleiter-Modul nach einem der Ansprüche 1 bis 19, **dadurch gekennzeichnet, dass** das Gehäuse (2) federnd ausgebildet ist.

25. Leistungshalbleiter-Modul nach einem der Ansprüche 1 bis 19 **dadurch gekennzeichnet, dass** das Gehäuse (2) ein erstes Gehäuseteil (21) und ein zweites Gehäuseteil (22) umfasst, wobei die mindestens zwei Halbleiterchips (3, 3') mit ihrer ersten und ihrer zweiten Hauptelektrodenseite (31, 32) zumindest teilweise von je einem Gehäuseteil (21, 22) umgeben sind und dass das erste und/oder zweite Gehäuseteil (21, 22) federnd ausgebildet ist.

26. Leistungshalbleiter-Modul nach Anspruch 1, **dadurch gekennzeichnet, dass** die mindestens zwei Halbleiterchips (3, 3') jeweils einen Steueranschluss (33) aufweisen, welcher parallel bezüglich der ersten oder der zweiten Hauptelektrodenseite (31, 32) des zugehörigen Halbleiterchips (3, 3') wegführt.

27. Leistungshalbleiter-Modul nach Anspruch 26, **dadurch gekennzeichnet, dass** das Leistungshalbleiter-Modul (1) eine Leiterplatte (9) umfasst,
die Leiterplatte (9) in der Ebene der mindestens zwei Halbleiterchips (3, 3') angeordnet ist und
jeder Steueranschluss (33) elektrisch mit der Leiterplatte (9) kontaktiert ist.

28. Leistungshalbleiter-Modul nach Anspruch 6, **dadurch gekennzeichnet, dass** das Gehäuse (2) ein erstes Gehäuseteil (21) und ein zweites Gehäuseteil (22) umfasst, wobei die mindestens zwei Halbleiterchips (3, 3') mit ihrer ersten und ihrer zweiten Hauptelektrodenseite (31, 32) zumindest teilweise von je einem Gehäuseteil (21, 22) umgeben sind, und dass die Kühlrippen (66) federnd ausgebildet sind.

29. Leistungshalbleiter-Modul nach Anspruch 13, **dadurch gekennzeichnet, dass** das Gehäuse (2) ein erstes Gehäuseteil (21) und ein zweites Gehäuseteil (22) umfasst, wobei die mindestens zwei Halbleiterchips (3, 3') mit ihrer ersten und ihrer zweiten Hauptelektrodenseite (31, 32) zumindest teilweise von je einem Gehäuseteil (21, 22) umgeben sind, und dass die Kühlrippen (76) federnd ausgebildet sind.

30. Leistungshalbleiter-Modul nach Anspruch 1, **dadurch gekennzeichnet, dass** der Kühlkörper (65) der ersten Kühlvorrichtung (6) und die ersten Hauptelektrodenanschlusselemente (61) einstückig ausgebildet sind.

31. Leistungshalbleiter-Modul nach Anspruch 7, **dadurch gekennzeichnet, dass** der Kühlkörper (75) der zweiten Kühlvorrichtung (7) und die zweiten Hauptelektrodeanschlusselemente einstückig ausgebildet sind.

## Claims

1. Power semiconductor module (1), comprising
- at least two semiconductor chips (3, 3') and at least two first and two second base plates (4, 4', 5, 5'), which at least two semiconductor chips (3, 3') each have a first main electrode side (31) and a second main electrode side (32) which is situated opposite the first main electrode side, wherein the respective first base plate (4, 4') makes thermal and electrical contact with the first main electrode side (31) in each case, and the respective second base plate (5, 5') makes thermal and electrical contact with the second main electrode side (32) in each case,
- a first cooling apparatus (6) having at least two first main electrode connection elements (61) and a heat sink (65), wherein that side of a first base plate (41) which is averted from the first main electrode side makes thermal and electrical contact with a first main electrode connection element (61) in each case, and wherein that side of the first main electrode connection element (62) which is averted from the first main electrode side makes thermal contact with the heat sink (65) in each case,
- a second cooling apparatus (7), that side of the respective second base plates (51) which is averted from the second main electrode side making thermal contact with the said second cooling apparatus, wherein the second cooling apparatus (7) has at least two second main electrode connection elements, wherein that side of a second base plate (51) which is averted from the second main electrode side makes thermal and electrical contact with a second main electrode connection element in each case, wherein the respective second main electrode connection elements make electrical contact with one another or the respective second main electrode connection elements are in the form of a common second main electrode connection element, and wherein the power semiconductor module (1) comprises a housing in which the at least two semiconductor chips (3, 3') and the first and the second cooling apparatus (6, 7) are arranged, and wherein the heat sink (65) of the first cooling apparatus (6), on that side which is situated opposite the first main electrode connection elements (61), is supported against the housing (2).

2. Power semiconductor module according to Claim 1, **characterized in that** the first main electrode connection elements (61) are electrically insulated from the housing (2).

3. Power semiconductor module according to Claim 1 or 2, **characterized in that** the heat sink (65) of the first cooling apparatus (6) is electrically insulated from the housing (2).

4. Power semiconductor module according to Claim 2 or 3, **characterized in that** the first main electrode connection elements (61) make electrical contact with the heat sink (65) of the first cooling apparatus (6).

5. Power semiconductor module according to one of Claims 1 to 3, **characterized in that** the heat sink (65) of the first cooling apparatus (6) is electrically insulated from the first main electrode connection elements (61).

6. Power semiconductor module according to one of Claims 1 to 5, **characterized in that** the heat sink (65) of the first cooling apparatus (6) has cooling ribs (66).

7. Power semiconductor module according to one of Claims 1 to 6, **characterized in that** the second cooling apparatus (7) comprises a heat sink (75), that side of the respective second main electrode connection element (72) which is averted from the second main electrode side making thermal contact with the said heat sink.

8. Power semiconductor module according to Claim 7, **characterized in that** the heat sink (75) of the second cooling apparatus (7), on that side which is situated opposite the second main electrode connection elements, is supported against the housing (2).

9. Power semiconductor module according to Claim 7 or 8, **characterized in that** the second main electrode connection elements are electrically insulated from the housing (2).

10. Power semiconductor module according to one of Claims 7 to 9, **characterized in that** the heat sink (75) of the second cooling apparatus (7) is electrically insulated from the housing (2).

11. Power semiconductor module according to Claim 9 or 10, **characterized in that** the second main electrode connection elements make electrical contact with the heat sink (75) of the second cooling apparatus (7).

12. Power semiconductor module according to one of Claims 7 to 10, **characterized in that** the heat sink (75) of the second cooling apparatus (7) is electrically insulated from the second main electrode connection elements.

13. Power semiconductor module according to one of Claims 7 to 12, **characterized in that** the heat sink (75) of the second cooling apparatus (7) has cooling ribs (76).

14. Power semiconductor module according to one of the preceding claims, **characterized in that** the respective first main electrode connection elements make electrical contact with one another or the respective first main electrode connection elements are in the form of a common first main electrode connection element.

15. Power semiconductor module according to Claim 14, **characterized in that**, in the case of a common first main electrode connection element, the common first main electrode connection element is in the form of a main electrode connection plate which has tapered portions between the regions in which contact is made with the at least two semiconductor chips (3, 3').

16. Power semiconductor module according to one of the preceding claims, **characterized in that**, in the case of a common second main electrode connection element, the common second main electrode connection element is in the form of a main electrode connection plate (73) which has tapered portions (74) between the regions in which contact is made with the at least two semiconductor chips (3, 3').

17. Power semiconductor module according to one of the preceding claims, **characterized in that** at least one semiconductor chip (3), which is arranged between a first and second base plate (4, 5), is connected in parallel with at least one second semiconductor chip (3'), which is arranged between a further first and second base plate (4', 5').

18. Power semiconductor module according to one of Claims 1 to 16, **characterized in that** at least one semiconductor chip (3), which is arranged between a first and second base plate (4, 5), is connected back-to-back in parallel with at least one second semiconductor chip (3'), which is arranged between a further first and second base plate (4', 5').

19. Power semiconductor module according to one of Claims 1 to 18, **characterized in that** at least one semiconductor chip (3), which is arranged between a first and second base plate (4, 5), is connected in series with at least one second semiconductor chip (3'), which is arranged between a further first and second base plate (4' 5').

20. Power semiconductor module according to one of the preceding claims, **characterized in that** the housing (2) comprises a first housing part (21) and a second housing part (22), wherein the at least two semiconductor chips (3, 3'), with their first and their second main electrode sides (31, 32), are surrounded at least partially by in each case one housing part (21, 22), and **in that** a flexible and compressible element (8) is arranged between the first cooling apparatus (6) and the first housing part (21).

21. Power semiconductor module according to one of the preceding claims, **characterized in that** the housing (2) comprises a first housing part (21) and a second housing part (22), wherein the at least two semiconductor chips (3, 3'), with their first and their second main electrode side (31, 32), are surrounded at least partially by in each case one housing part (21, 22), and **in that** a flexible and compressible element (8) is arranged between the second cooling apparatus (7) and the second housing part (22).

22. Power semiconductor module according to either of Claims 20 and 21, **characterized in that** the flexible and compressible element (8) is a spring element, in particular an elastomeric, polymeric, plastic, metal or gas-pressure spring element.

23. Power semiconductor module according to one of Claims 1 to 19, **characterized in that** the housing (2) is of integral design.

24. Power semiconductor module according to one of Claims 1 to 19, **characterized in that** the housing (2) is of resilient design.

25. Power semiconductor module according to one of Claims 1 to 19, **characterized in that** the housing (2) comprises a first housing part (21) and a second housing part (22), wherein the at least two semiconductor chips (3, 3'), with their first and their second main electrode side (31, 32), are surrounded at least partially by in each case one housing part (21, 22), and **in that** the first and/or second housing part (21, 22) is of resilient design.

26. Power semiconductor module according to Claim 1, **characterized in that** the at least two semiconductor chips (3, 3') each have a control connection (33) which leads away parallel with respect to the first or the second main electrode side (31, 32) of the associated semiconductor chip (3, 3').

27. Power semiconductor module according to Claim 26, **characterized in that** the power semiconductor module (1) comprises a printed circuit board (9) which is arranged in the plane of the at least two semiconductor chips (3, 3'), and the printed circuit board (9) makes electrical contact with each control connection (33).

28. Power semiconductor module according to Claim 6, **characterized in that** the housing (2) comprises a first housing part (21) and a second housing part (22), wherein the at least two semiconductor chips (3, 3'), with their first and their second main electrode side (31, 32), are surrounded at least partially by in each case one housing part (21, 22), and **in that** the cooling ribs (66) are of resilient design.

29. Power semiconductor module according to Claim 13, **characterized in that** the housing (2) comprises a first housing part (21) and a second housing part (22), wherein the at least two semiconductor chips (3, 3'), with their first and their second main electrode side (31, 32), are surrounded at least partially by in each case one housing part (21, 22), and **in that** the cooling ribs (76) are of the resilient design.

30. Power semiconductor module according to Claim 1, **characterized in that** the heat sink (65) of the first cooling apparatus (6) and the first main electrode connection elements (61) are of integral design.

31. Power semiconductor module according to Claim 7, **characterized in that** the heat sink (75) of the second cooling apparatus (7) and the second main electrode connection elements are of integral design.

## Revendications

1. Module (1) de semi-conducteur de puissance comprenant :
au moins deux puces semi-conductrices (3, 3') et au moins deux premières et deux deuxièmes plaques de base (4, 4', 5, 5') qui présentent au moins deux puces semi-conductrices (3, 3') et chacune un premier côté (31) d'électrode principale et un deuxième côté (32) d'électrode principale opposé au premier côté d'électrode principale, chaque côté (31) d'électrode principale étant en contact thermique et électrique avec la première plaque de base (4, 4') respective et chaque deuxième côté (32) d'électrode principale étant en contact thermique et électrique avec chaque deuxième plaque de base (5, 5'),
un premier dispositif de refroidissement (6) qui présente au moins deux premiers éléments (61) de raccordement d'électrode principale et un corps de refroidissement (65), chaque premier élément (61) de raccordement d'électrode principale étant en contact thermique et électrique avec le côté d'une première plaque de base (41) non tourné vers le premier côté d'électrode principale et chaque corps de refroidissement (65) étant en contact thermique avec le côté du premier élément (62) de raccordement d'électrode principale non tourné vers le premier côté d'électrode principale,
un deuxième dispositif de refroidissement (7) en contact thermique avec le côté de la deuxième plaque de base (51) non tourné vers le deuxième côté d'électrode principale, le deuxième dispositif de refroidissement (7) présentant au moins deux deuxièmes éléments de raccordement d'électrode principale, chaque deuxième élément de raccordement d'électrode principale étant en contact thermique et électrique avec le côté d'une deuxième plaque de base (51) non tourné vers le deuxième côté d'électrode principale, les deuxièmes éléments de raccordement d'électrode principale étant en contact électrique mutuel et les deuxièmes éléments de raccordement d'électrode principale étant configurés comme deuxième élément commun de raccordement d'électrode principale,
le module (1) de semi-conducteur de puissance comportant un boîtier dans lequel au moins deux puces semi-conductrices (3, 3') et le premier et le deuxième dispositif de refroidissement (6, 7) sont disposés,
le corps de refroidissement (65) du premier dispositif de refroidissement (6) s'appuyant contre le boîtier (2) sur le côté opposé aux premiers éléments (61) de raccordement d'électrode principale.

2. Module de semi-conducteur de puissance selon la revendication 1, **caractérisé en ce que** les premiers éléments (61) de raccordement d'électrode principale sont isolés électriquement vis-à-vis du boîtier (2).

3. Module de semi-conducteur de puissance selon les revendications 1 ou 2, **caractérisé en ce que** le corps de refroidissement (65) du premier dispositif de refroidissement (6) est isolé électriquement vis-à-vis du boîtier (2).

4. Module de semi-conducteur de puissance selon les revendications 2 ou 3, **caractérisé en ce que** le corps de refroidissement (65) du premier dispositif de refroidissement (6) est en contact électrique avec les premiers éléments (61) de raccordement d'électrode principale.

5. Module de semi-conducteur de puissance selon l'une des revendications 1 à 3, **caractérisé en ce que** le corps de refroidissement (65) du premier dispositif de refroidissement (6) est isolé électriquement vis-à-vis des premiers éléments (61) de raccordement d'électrode principale.

6. Module de semi-conducteur de puissance selon l'une des revendications 1 à 5, **caractérisé en ce que** le corps de refroidissement (65) du premier dispositif de refroidissement (6) présente des ailettes de refroidissement (66).

7. Module de semi-conducteur de puissance selon l'une des revendications 1 à 6, **caractérisé en ce que** le deuxième dispositif de refroidissement (7) comporte un corps de refroidissement (75) en contact thermique avec le côté de chaque deuxième élément (72) de raccordement d'électrode principale non tourné vers le deuxième côté d'électrode principale.

8. Module de semi-conducteur de puissance selon la revendication 7, **caractérisé en ce que** le corps de refroidissement (75) du deuxième dispositif de refroidissement (7) s'appuie contre le boîtier (2) sur le côté opposé aux deuxièmes éléments de raccordement d'électrode principale.

9. Module de semi-conducteur de puissance selon les revendications 7 ou 8, **caractérisé en ce que** les deuxièmes éléments de raccordement d'électrode principale sont isolés électriquement vis-à-vis du boîtier (2).

10. Module de semi-conducteur de puissance selon l'une des revendications 7 à 9, **caractérisé en ce que** le corps de refroidissement (75) du deuxième dispositif de refroidissement (7) est isolé électriquement vis-à-vis du boîtier (2).

11. Module de semi-conducteur de puissance selon les revendications 9 ou 10, **caractérisé en ce que** le corps de refroidissement (75) du deuxième dispositif de refroidissement (7) est en contact électrique avec les deuxièmes éléments de raccordement d'électrode principale.

12. Module de semi-conducteur de puissance selon l'une des revendications 7 à 10, **caractérisé en ce que** le corps de refroidissement (75) du deuxième dispositif de refroidissement (7) est isolé électriquement vis-à-vis des deuxièmes éléments de raccordement d'électrode principale.

13. Module de semi-conducteur de puissance selon l'une des revendications 7 à 12, **caractérisé en ce que** le corps de refroidissement (75) du deuxième dispositif de refroidissement (7) présente des ailettes de refroidissement (76).

14. Module de semi-conducteur de puissance selon l'une des revendications précédentes, **caractérisé en ce que** les deuxièmes éléments de raccordement d'électrode principale sont mis en contact électrique mutuel ou **en ce que** les premiers éléments de raccordement d'électrode principale sont configurés comme premier élément commun de raccordement d'électrode principale.

15. Module de semi-conducteur de puissance selon la revendication 14, **caractérisé en ce que** dans le cas d'un premier élément commun de raccordement d'électrode principale, le premier élément commun de raccordement d'électrode principale est configuré comme plaque de raccordement d'électrode principale qui présente des rétrécissements entre les parties dans lesquelles les deux ou plusieurs puces semi-conductrices (3, 3') sont en contact.

16. Module de semi-conducteur de puissance selon l'une des revendications précédentes, **caractérisé en ce que** dans le cas d'un deuxième élément commun de raccordement d'électrode principale, le deuxième élément commun de raccordement d'électrode principale est configuré comme plaque (73) de raccordement d'électrode principale qui présente des rétrécissements (74) entre les parties dans lesquelles les deux ou plusieurs puces semi-conductrices (3, 3') sont en contact.

17. Module de semi-conducteur de puissance selon l'une des revendications précédentes, **caractérisé en ce qu'**au moins une puce semi-conductrice (3) disposée entre la première et la deuxième plaque de base (4, 5) est raccordée en parallèle à au moins une deuxième puce semi-conductrice (3') disposée entre une autre premier et une autre deuxième plaque de base (4', 5').

18. Module de semi-conducteur de puissance selon l'une des revendications 1 à 16, **caractérisé en ce qu'**au moins une puce semi-conductrice (3) disposée entre une premier et une deuxième plaque de base (4, 5) est raccordée de manière antiparallèle à au moins une deuxième puce semi-conductrice (3') disposée entre une autre première et une autre deuxième plaque de base (4', 5').

19. Module de semi-conducteur de puissance selon l'une des revendications 1 à 18, **caractérisé en ce qu'**au moins une puce semi-conductrice (3) disposée entre une première et une deuxième plaque de base (4, 5) est raccordée en série à au moins une deuxième puce semi-conductrice (3') disposée entre une autre première et une autre deuxième plaque de base (4', 5').

20. Module de semi-conducteur de puissance selon l'une des revendications précédentes, **caractérisé en ce que** le boîtier (2) comporte une première partie de boîtier (21) et une deuxième partie de boîtier (22), les deux ou plusieurs puces semi-conductrices (3, 3') étant entourées au moins en partie par une partie de boîtier (21, 22) sur leurs premiers et leurs deuxièmes côtés (31, 32) d'électrode principale et **en ce qu'**un élément flexible et compressible (8) est disposé entre le premier dispositif de refroidissement (6) et la première partie de boîtier (21).

21. Module de semi-conducteur de puissance selon l'une des revendications précédentes, **caractérisé en ce que** le boîtier (2) comporte une première partie de boîtier (21) et une deuxième partie de boîtier (22), les deux ou plusieurs puces semi-conductrices (3, 3') étant entourées au moins en partie par une partie de boîtier (21, 22) sur leurs premiers et leurs deuxièmes côtés (31, 32) d'électrode principale et **en ce qu'**un élément flexible et compressible (8) est disposé entre le deuxième dispositif de refroidissement (7) et la deuxième partie de boîtier (22).

22. Module de semi-conducteur de puissance selon l'une des revendications 20 ou 21, **caractérisé en ce que** l'élément flexible et compressible (8) est un élément élastique, en particulier un élément élastique en élastomère, en polymère, en matière synthétique, en métal ou à pression de gaz.

23. Module de semi-conducteur de puissance selon l'une des revendications 1 à 19, **caractérisé en ce que** le boîtier (2) est réalisé d'une seule pièce.

24. Module de semi-conducteur de puissance selon l'une des revendications 1 à 19, **caractérisé en ce que** le boîtier (2) est élastique.

25. Module de semi-conducteur de puissance selon l'une des revendications 1 à 19, **caractérisé en ce que** le boîtier (2) comporte une première partie de boîtier (21) et une deuxième partie de boîtier (22), les deux ou plusieurs puces semi-conductrices (3, 3') étant entourées au moins en partie par une partie de boîtier (21, 22) sur leur premier et leur deuxième côté (31, 32) d'électrode principale et **en ce que** la première et/ou la deuxième partie de boîtier (21, 22) sont élastiques.

26. Module de semi-conducteur de puissance selon la revendication 1, **caractérisé en ce que** les deux ou plusieurs puces semi-conductrices (3, 3') présentent chacune une borne de commande (33) qui s'éloignent parallèlement au premier ou au deuxième côté (31, 32) d'électrode principale de la puce semi-conductrice (3, 3') associée.

27. Module de semi-conducteur de puissance selon la revendication 26, **caractérisé en ce que** le module (1) de semi-conducteur de puissance comporte une carte de circuit (9), en ce la carte de circuit (9) est disposée dans le plan des deux ou plusieurs puces semi-conductrices (3, 3') et **en ce que** chaque borne de commande (33) est en contact électrique avec la carte de circuit (9).

28. Module de semi-conducteur de puissance selon la revendication 6, **caractérisé en ce que** le boîtier (2) comporte une première partie de boîtier (21) et une deuxième partie de boîtier (22), les deux ou plusieurs puces semi-conductrices (3, 3') étant entourées au moins en partie par une partie de boîtier (21, 22) sur leur premier et leur deuxième côté (31, 33) d'électrode principale et **en ce que** les ailettes de refroidissement (66) sont élastiques.

29. Module de semi-conducteur de puissance selon la revendication 13, **caractérisé en ce que** le boîtier (2) présente une première partie de boîtier (21) et une deuxième partie de boîtier (22), les deux ou plusieurs puces semi-conductrices (3, 3') étant entourées au moins en partie par une partie de boîtier (21, 22) sur leur premier et leur deuxième côté (31, 32) d'électrode principale et **en ce que** les nervures de refroidissement (76) sont élastiques.

30. Module de semi-conducteur de puissance selon la revendication 1, **caractérisé en ce que** le corps de refroidissement (65) du premier dispositif de refroidissement (6) et les premiers éléments (61) de raccordement d'électrode principale sont réalisés d'une seule pièce.

31. Module de semi-conducteur de puissance selon la revendication 7, **caractérisé en ce que** le corps de refroidissement (75) du premier dispositif de refroidissement (7) et les deuxièmes éléments (61) de raccordement d'électrode principale sont réalisés d'une seule pièce.
